# EUROPEAN PATENT APPLICATION

(11) **EP 4 529 969 A1**
(43) Date of publication of application: **02.04.2025**
(21) Application number: 23811000.1
(22) Date of filing: 22.05.2023
(51) Int. Cl.: B01D 45/06, B01D 53/00, H01L 21/67

(54) **CONDENSATE WATER SEPARATION DEVICE AND SEMICONDUCTOR PROCESS DEVICE**

(30) Priority: 23.05.2022 CN 202210565094
(71) Applicant: Beijing NAURA Microelectronics Equipment Co., Ltd., Beijing 100176 (CN)
(72) Inventor: GUANG, Yaohua, Beijing 100176 (CN); SHI, Lei, Beijing 100176 (CN); WANG, Lika, Beijing 100176 (CN)
(74) Representative: Cohausz & Florack
(86) International application number: PCT/CN2023/095512
(87) International publication number: WO 2023/226929

(57) **Abstract**

There is provided a condensate water separation device applied to a gas discharge system of a semiconductor process device, the gas discharge system includes an exhaust pipeline, a pressure control valve group (5) is disposed on the exhaust pipeline, and the condensate water separation device includes: a device body (1), which is provided therein with a zigzag gas passage, the gas passage including a plurality of passages sequentially communicated with each other along a gas flow direction, a gas inlet end (A1) of a most upstream passage (1a) being used as a gas inlet and configured to be connected to an outlet end of the pressure control valve group (5), a gas outlet end (A4) of a most downstream passage (1d) being used as a gas outlet and being higher than a gas inlet end of the downstream passage (1d), and at least one other passage having a gas outlet end lower than a gas inlet end; and a one-way drainage structure (7), which is connected to a joint between the at least one other passage having the gas outlet end lower than the gas inlet end and the passage downstream therefrom, and is configured to drain condensate water flowing through the one-way drainage structure (7). There is further provided a semiconductor process device, including a reaction chamber (34) and a gas discharge system, and the gas discharge system includes: an exhaust pipeline connected to the reaction chamber (34); a pressure control valve group (5) disposed on the exhaust pipeline; and the condensate water separation device having the gas inlet connected to an outlet end of the pressure control valve group (5).

## Description

### TECHNICAL FIELD

The present disclosure belongs to the technical field of semiconductor process devices, and particularly relates to a condensate water separation device and a semiconductor process device.

### BACKGROUND

Among semiconductor process devices, a diffusion furnace is, for example, one of important process devices for a front process of an integrated circuit production line, and is mainly used for doping of a semiconductor. Although an ion implantation method may be used in some processes for doping, thermal diffusion is still the most dominant and prevalent doping method. Thermal oxidation of silicon is to enable a surface of a silicon wafer to react with oxidant at a high temperature to grow a layer of silicon dioxide film, and there are two oxidation methods, i.e., dry oxidation and wet oxidation. Thickness, uniformity, and particle content of an oxide film are key indexes for evaluating a vertical furnace, many factors may affect those indexes, and one of the important factors is stability of chamber pressure.

The diffusion furnace generally includes five basic components: a control system, a process furnace tube, a gas conveying system, a gas discharge system, and a loading system. The gas discharge system is connected to a plant system including a plant exhaust unit and a plant water drainage unit, and is configured to discharge a by-product generated during the process and an unused raw material gas, and the gas discharge system is also configured to control a pressure in a chamber to fluctuate within a certain range. A pressure control valve group in the gas discharge system is a key part for realizing stable control of the pressure in the chamber. Various factors may affect stability of pressure control, and a temperature of a process waste gas, a content of condensate water, and a content of impurities are main influencing factors.

**In** the gas discharge system of the existing semiconductor process device, the pressure control valve group can be easily influenced by condensate water flowing back from the plant exhaust unit, resulting in an unstable pressure control effect of the pressure control valve group, and even damage to a valve body.

### SUMMARY

**In** view of the disadvantages in the prior art, the present disclosure provides a condensate water separation device and a semiconductor process device, and the condensate water separation device is disposed at an outlet end of a pressure control valve group of a gas discharge system, and can prevent condensate water which flows back from entering the pressure control valve group.

In order to achieve the above objective, the present disclosure provides a condensate water separation device, the condensate water separation device is applied to a gas discharge system of a semiconductor process device, the gas discharge system includes an exhaust pipeline, a pressure control valve group is disposed on the exhaust pipeline, and the condensate water separation device includes:
a device body, which is provided therein with a zigzag gas passage, the gas passage including a plurality of passages sequentially communicated with each other along a gas flow direction, and a gas inlet end of a most upstream passage of the plurality of passages being used as a gas inlet and configured to be connected to an outlet end of the pressure control valve group; a gas outlet end of a most downstream passage of the plurality of passages being used as a gas outlet and being higher than a gas inlet end of the most downstream passage; and at least one other passage of the plurality of passages having a gas inlet end and a gas outlet end lower than the gas inlet end; and
a one-way drainage structure, which is connected to a joint between the at least one other passage having the gas outlet end lower than the gas inlet end and a passage downstream therefrom, and is configured to drain condensate water flowing through the one-way drainage structure.

Optionally, the plurality of passages include a first passage, a second passage, and a third passage, a lower end of the first passage is open to form the gas inlet, an upper end of the first passage is connected to a gas inlet end of the second passage through the third passage which inclines downwards, and an upper end of the second passage is open to form the gas outlet; and the gas inlet end of the second passage is lower than the upper end of the second passage; and
one end of the one-way drainage structure is connected to a lower end of the second passage, and the other end of the one-way drainage structure forms a drainage port.

Optionally, the second passage includes a first sub-passage and an oblique second sub-passage, an axis of the first sub-passage is parallel to an axis of the first passage, the first sub-passage is provided with the gas inlet end of the second passage, and is connected to the upper end of the first passage through the third passage, and a lower end of the first sub-passage is connected to one end of the one-way drainage structure; and the first sub-passage is further provided with a gas outlet end connected to a lower end of the second sub-passage, and the gas outlet end of the first sub-passage is higher than the gas inlet end of the second passage; and
an upper end of the second sub-passage forms the gas outlet at the device body, and the gas outlet is disposed coaxially with the gas inlet.

Optionally, the one-way drainage structure includes:
a valve body, which is provided therein with a valve cavity, the valve cavity including a first straight tube section, a tapered section, and a second straight tube section, which are connected to each other in sequence, and a liquid inlet being formed at the valve body at one end of the second straight tube section away from the tapered section and being connected to a joint of each passage having a gas outlet end lower than a gas inlet end and a passage downstream therefrom; and
a partition plate, which is disposed in the first straight tube section, and is provided with a plurality of through holes that connect two sides of the partition plate, a sphere being disposed on a side of the partition plate close to the tapered section and being in sliding fit with the first straight tube section, an elastic part being disposed between the sphere and the partition plate and being capable of applying, through an elastic force of the elastic part, an elastic force to the sphere in a direction towards the tapered section so as to enable the sphere to be in contact with an inner wall of the tapered section and block the valve cavity, and the first straight tube section forming the drainage port at the valve body on a side of the partition plate away from the tapered section.

Optionally, the one-way drainage structure further includes:
a first connecting pipe, the liquid inlet being connected to the joint between each passage having a gas outlet end lower than a gas inlet end and the passage downstream therefrom through the first connecting pipe; and the valve body being detachably connected to the first connecting pipe; and
a fourth connecting pipe, which is detachably connected to the valve body, and is communicated with the drainage port.

Optionally, the gas inlet is connected to a second connecting pipe, and a heating part is provided around the second connecting pipe.

Optionally, the heating part includes a heating wire spirally wound around the second connecting pipe.

Optionally, the gas outlet is connected to a third connecting pipe, and a refrigeration part is disposed around the third connecting pipe.

Optionally, the refrigeration part includes a cooling jacket, a cooling cavity is provided in the cooling jacket, and a water inlet pipe and a water outlet pipe which are communicated with the cooling cavity are disposed at an outer side of the cooling jacket.

Optionally, a temperature sensor is disposed in the second passage.

The present disclosure further provides a semiconductor process device, including a reaction chamber and a gas discharge system, and the gas discharge system includes:
an exhaust pipeline connected to the reaction chamber;
a pressure control valve group disposed on the exhaust pipeline; and
the condensate water separation device as described above, the gas inlet of the condensate water separation device being detachably connected to an outlet end of the pressure control valve group.

Optionally, the semiconductor process device further includes:
a tail-gas condensation device, a gas-liquid separation device, and a condensate water drainage device;
the gas-liquid separation device is connected to the reaction chamber through a first pipeline, the tail-gas condensation device is disposed on the first pipeline, and a liquid outlet end and a gas outlet end of the gas-liquid separation device are connected to the condensate water drainage device and the pressure control valve group through a second pipeline and a third pipeline, respectively; and
the gas outlet of the condensate water separation device is configured to be connected to an exhaust unit of a plant system, the drainage port of the condensate water separation device is configured to be connected to a water drainage unit of the plant system, and the condensate water drainage device is connected to the water drainage unit through a fourth pipeline.

The condensate water separation device provided in the present disclosure has the following beneficial effects.
1. The condensate water separation device is disposed at the outlet end of the pressure control valve group of the gas discharge system of the semiconductor process device, the device body of the condensate water separation device is provided therein with the zigzag gas passage including the plurality of passages sequentially communicated with each other along the gas flow direction, and the gas inlet end of the most upstream passage is used as the gas inlet, and is configured to be connected to the outlet end of the pressure control valve group; the gas outlet end of the most downstream passage is used as the gas outlet, and is higher than the gas inlet end of the most downstream passage; and at least one other passage has a gas outlet end lower than a gas inlet end. A gas enters from the gas inlet, passes through the zigzag gas passage, and then is discharged from the gas outlet. By setting the gas outlet end of at least one passage to be lower than the gas inlet end thereof, the condensate water which flows back can hardly flow into a passage upstream from the at least one passage after entering the at least one passage, and can be drained through the one-way drainage structure, so that the condensate water which flows back can be prevented from entering the pressure control valve group;
2. The condensate water separation device is connected to the exhaust unit of the plant system and the water drainage unit of the plant system through the second connecting pipe and the third connecting pipe respectively, and the heating part and the refrigeration part are disposed around the second connecting pipe and the third connecting pipe respectively. The heating part can heat a gas entering the first passage, so that condensate water in the first passage can be prevented from flowing back to the pressure control valve group. The refrigeration part can promote a condensation effect of the third connecting pipe on an upper end of the second passage, and enable the condensate water in the third connecting pipe to flow into the lower end of the second passage and be drained through the one-way drainage structure, which further prevents the condensate water from flowing back into the pressure control valve group;
3. In the gas discharge system of the semiconductor process device, the condensation water separation device is disposed between the outlet end of the pressure control valve group and the exhaust unit of the plant system, two times of condensation are realized by the tail-gas condensation device and the refrigeration part in the condensation water separation device, so that a gas and a liquid in a tail gas can be effectively separated from each other. The condensate water in the third connecting pipe on the upper end of the second passage and the condensate water in the exhaust unit can be drained through the second passage and the one-way drainage structure, so that the condensate water can hardly enter the first passage and thus can hardly flow back into the pressure control valve group.

The other features and advantages of the present disclosure will be described in detail in the following detailed embodiments.

### BRIEF DESCRIPTION OF DRAWINGS

The above and other objectives, features and advantages of the present disclosure will become more apparent from the following description of exemplary implementations of the present disclosure with reference to the accompanying drawings. In the exemplary implementations of the present disclosure, the same reference numeral generally denotes the same element.
FIG. 1 is a schematic structural diagram of a zigzag gas passage according to an embodiment of the present disclosure.
FIG. 2 is a schematic structural diagram of a condensate water separation device according to an embodiment of the present disclosure.
FIG. 3 is a schematic structural diagram of a one-way drainage structure of a condensate water separation device according to an embodiment of the present disclosure.
FIG. 4 a sectional view taken along A-A of FIG. 3.
FIG. 5 is a schematic structural diagram of a gas discharge system according to an embodiment of the present disclosure.

Reference numerals:
1-device body; 1a-most upstream passage; 1b-first intermediate passage; 1c-second intermediate passage; 1d-most downstream passage; A1-gas inlet; A2-gas outlet end of first intermediate passage; A3- gas outlet end of second intermediate passage; A4-gas outlet; 2-first passage; 3-second passage; 4-third passage; 5-pressure control valve group; 6-exhaust unit; 7-one-way drainage structure; 8-first connecting pipe; 9-water drainage unit; 10-second connecting pipe; 11-heating part; 12-third connecting pipe; 13-refrigeration part; 14-first sub-passage; 15-second sub-passage; 16-valve body; 17-first straight tube section; 18-tapered section; 19-second straight tube section; 20-partition plate; 21-through hole; 22-sphere; 23-elastic part; 24-fourth connecting pipe; 25-temperature sensor; 26-water inlet pipe; 27-water outlet pipe; 28-tail-gas condensation device; 29-gas-liquid separation device; 30-condensate water drainage device; 31-first pipeline; 32-second pipeline; 33-third pipeline; 34-reaction chamber; 35-fourth pipeline.

### DETAIL DESCRIPTION OF EMBODIMENTS

Exemplary implementations of the present disclosure will be described in detail below. Although the exemplary implementations of the present disclosure are described below, it should be understood that the present disclosure may be implemented in various forms and should not be limited to the implementations described herein. Rather, the implementations are provided to facilitate thorough and complete understanding of the present disclosure and fully convey the scope of the present disclosure to those of ordinary skill in the art.

### Embodiments

The present disclosure provides a condensate water separation device applied to a gas discharge system of a semiconductor process device, the gas discharge system includes an exhaust pipeline, and a pressure control valve group is disposed on the exhaust pipeline. The condensate water separation device includes a device body 1 and a one-way drainage structure 7.

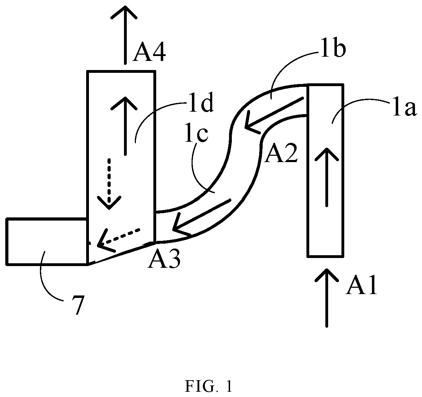

The device body 1 is provided therein with a zigzag gas passage, which includes a plurality of passages sequentially communicated with each other along a gas flow direction. For example, a gas passage shown in FIG. 1 includes four passages, which are a most upstream passage 1a, a first intermediate passage 1b, a second intermediate passage 1c, and a most downstream passage 1d sequentially arranged along the gas flow direction, a gas inlet end A1 of the most upstream passage 1a is used as a gas inlet and is configured to be connected to an outlet end of the pressure control valve group; a gas outlet end A4 of the most downstream passage 1d is used as a gas outlet, and is higher than a gas inlet end A3 of the most downstream passage 1d; and for each of the other two passages, a gas outlet end is lower than a gas inlet end, that is, the gas outlet end A2 of the first intermediate passage 1b is lower than the gas inlet end of the first intermediate passage 1b, and the gas outlet end A3 of the second intermediate passage 1c is lower than the gas inlet end of the second intermediate passage 1c.

The one-way drainage structure 7 is connected to a joint between a passage having a gas outlet end (e.g., the gas outlet end A3 of the second intermediate passage 1c) lower than a gas inlet end and a passage downstream therefrom (i.e., the most downstream passage 1d), and is configured to drain condensate water flowing through the one-way drainage structure 7.

The gas flow direction is shown by the solid arrows in FIG. 1, and a flow direction of the condensate water is shown by the dotted arrows in FIG. 1. A gas enters from the gas inlet (i.e., the gas inlet end A1 of the most upstream passage 1a), passes through the zigzag gas passage, and then is discharged from the gas outlet (i.e., the gas outlet end A4 of the most downstream passage 1d). By setting the gas outlet end of at least one passage (i.e., the first intermediate passage 1b and the second intermediate passage 1c) to be lower than the gas inlet end, the condensate water which flows back can hardly flow into a passage upstream from the at least one passage again after entering the at least one passage, and can be drained through the one-way drainage structure 7, so that the condensate water which flows back can be prevented from entering the pressure control valve group.

It should be noted that, as shown in FIG. 1, two passages (i.e., the first intermediate passage 1b and the second intermediate passage 1c) are connected between the most upstream passage 1a and the most downstream passage 1d, but the embodiments of the present disclosure are not limited thereto, and one passage or three or more passages may be connected between the most upstream passage 1a and the most downstream passage 1d in practical applications. Moreover, as shown in FIG. 1, each of the first intermediate passage 1b and the second intermediate passage 1c has the gas outlet end lower than the gas inlet end, but the embodiments of the present disclosure are not limited thereto, and it may be the case that only one intermediate passage has the gas outlet end lower than the gas inlet end in practical applications. In addition, as shown in FIG. 1, the one-way drainage structure 7 is connected to the joint between the gas outlet end A3 of the second intermediate passage 1c and the passage downstream therefrom (i.e., the downstream passage 1d), but the embodiments of the present disclosure are not limited thereto. In practical applications, the one-way drainage structure 7 may be connected to a joint between the gas outlet end A2 of the first intermediate passage 1b and the passage downstream therefrom (i.e., the second intermediate passage 1c); or, two one-way drainage structures 7 are provided, and are connected to the joint between the gas outlet end A3 of the second intermediate passage 1c and the passage downstream therefrom and the joint between the gas outlet end A2 of the first intermediate passage 1b and the passage downstream therefrom, respectively.

It should be noted that, as shown in FIG. 1, both the most upstream passage 1a and the most downstream passage 1d are vertically disposed straight passages, and both the first intermediate passage 1b and the second intermediate passage 1c are curved passages, but the embodiments of the present disclosure are not limited thereto, and each passage may be set in any shape according to specific needs in practical applications.

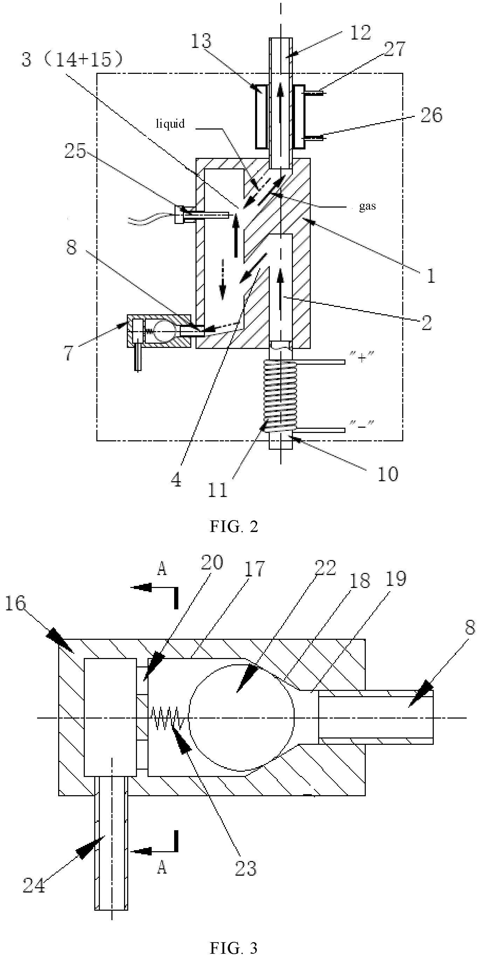

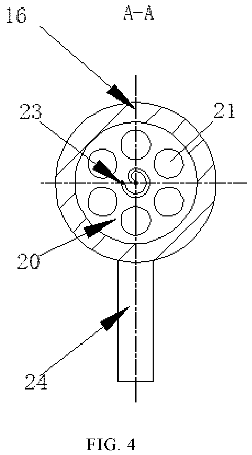

In an exemplary embodiment, as shown in FIG. 2 to FIG. 5, the plurality of passages include a first passage 2, a second passage 3, and a third passage 4, a lower end of the first passage 2 is open to form the gas inlet, the gas inlet is configured to be connected to the outlet end of the pressure control valve group 5, an upper end of the first passage 2 is connected to a gas inlet end of the second passage 3 through the third passage 4 which inclines downwards, and an upper end of the second passage 3 is open to form the gas outlet; and the gas inlet end of the second passage 3 is lower than the upper end of the second passage 3.

One end of the one-way drainage structure 7 is connected to a lower end of the second passage 3, and the other end of the one-way drainage structure 7 forms a drainage port.

The condensate water separation device is disposed downstream from the pressure control valve group 5 of the gas discharge system of the semiconductor apparatus, the first passage 2 and the second passage 3 are independent of each other, and are connected through the oblique third passage 4 to form the zigzag gas passage. The gas enters from the gas inlet, passes through the zigzag gas passage, and then is discharged from the gas outlet. After entering the second passage 3, the condensate water which flows back can hardly flow into the first passage 2, and can be drained through the one-way drainage structure 7, so that the condensate water which flows back can be prevented from entering the pressure control valve group 5.

Furthermore, a plant system includes an exhaust unit 6 and a water drainage unit 9, the gas outlet is connected to the exhaust unit 6, and the drainage port is connected to the water drainage unit 9. The first passage 2 and the second passage 3 are independent of each other, and are connected through the oblique third passage 4 to form the zigzag gas passage. The gas enters from the gas inlet, passes through the zigzag gas passage, and then is discharged to the exhaust unit 6 through the gas outlet. After entering the second passage 3, the condensate water in the exhaust unit 6 can hardly flow into the first passage 2, and can be drained to the water drainage unit 9 through the one-way drainage structure 7, so that the condensate water which flows back from the exhaust unit 6 can be prevented from entering the pressure control valve group 5. Thus, the condensate water in the water drainage unit 9 and a corrosive by-product from a reaction chamber 34 can be effectively prevented from adversely affecting the pressure control valve group.

Optionally, the first passage 2 and the second passage 3 are both vertically disposed and parallel to each other, an upper end of the third passage 4 is connected to the upper end of the first passage 2, and a lower end of the third passage 4 is connected to a side wall of the second passage 3 close to the lower end of the second passage 3. In this way, a storage space capable of storing a certain amount of liquid is formed in a lower part of the second passage 3, which facilitates discharging the liquid from the storage space periodically or quantitatively.

Optionally, the gas inlet is connected to a second connecting pipe 10, and a heating part 11 is provided around the second connecting pipe 10.

The second connecting pipe 10 may be connected to the gas inlet and a pipeline of the outlet end of the pressure control valve group 5 through threaded connection, so as to form detachable connection and facilitate repair, maintenance and replacement. Under a heating effect of the heating part 11 on the second connecting pipe 10 and a gas therein, a temperature of the gas is raised to 100C, so as to prevent condensate water in the second connecting pipe 10 from flowing back to the pressure control valve group.

Optionally, the gas outlet is connected to a third connecting pipe 12, and a refrigeration part 13 is disposed around the third connecting pipe 12.

The third connecting pipe 12 may be connected to the gas outlet and a pipeline of an inlet end of the exhaust unit 6 through threaded connection, so as to form detachable connection and facilitate repair, maintenance and replacement. Under a cooling effect of the refrigeration part 13 on the third connecting pipe 12 and a gas therein, water vapor is promoted to condense in the third connecting pipe 12, and an obtained condensate liquid flows back into the second passage 3 and may be discharged through the one-way drainage structure 7, so as to prevent the condensate liquid in the third connecting pipe 12 and the exhaust unit 6 from flowing back into the pressure control valve group.

Optionally, the second passage 3 includes a first sub-passage 14 and an oblique second sub-passage 15, the first sub-passage 14 is disposed on a side of the first passage 2, an axis of the first sub-passage 14 is parallel to an axis of the first passage 2, the first sub-passage 14 is provided with the gas inlet end of the second passage 3, and is connected to the upper end of the first passage 2 through the third passage 4, and a lower end of the first sub-passage 14 is connected to one end of the one-way drainage structure 7; the first sub-passage 14 is further provided with a gas outlet end connected to a lower end of the second sub-passage 15, and the gas outlet end is higher than the gas inlet end of the second passage 3; and an upper end of the second sub-passage 15 forms the gas outlet at the device body 1, and the gas outlet is disposed coaxially with the gas inlet.

The arrangement of the oblique second sub-passage 15 allows a position of the gas outlet to correspond to a position of the gas inlet, so that coaxially arrangement of the gas outlet and the gas inlet can be realized. Thus, through the detachable connection of the second connecting pipe 10 and the detachable connection of the third connecting pipe 12, the condensation water separation device can be easily mounted on an existing straight pipeline between the pressure control valve group 5 and the exhaust unit 6, and an improvement to the existing gas discharge system can be facilitated.

Optionally, the one-way drainage structure 7 includes a valve body 16 and a partition plate 20.

A valve cavity is provided in the valve body 16, and includes a first straight tube section 17, a tapered section 18, and a second straight tube section 19, which are connected to each other in sequence, and a liquid inlet is formed at the valve body 16 at one end of the second straight tube section 19 away from the tapered section 18, and is connected to a joint of each passage (e.g., the third passage 4) having a gas outlet end lower than a gas inlet end and a passage downstream therefrom (e.g., the second passage 3).

The partition plate 20 is disposed in the first straight tube section 17, and is provided with a plurality of through holes 21 that connect two sides of the partition plate 20. A sphere 22 is disposed on a side of the partition plate 20 close to the tapered section 18, and is in sliding fit with the first straight tube section 17. An elastic part 23 is disposed between the sphere 22 and the partition plate 20, and may apply, through an elastic force of the elastic part 23, an elastic force to the sphere 22 in a direction towards the tapered section 18, so that the sphere 22 is made to be in contact with an inner wall of the tapered section 18 and block the valve cavity. The first straight tube section 17 forms the drainage port at the valve body 16 on a side of the partition plate 20 away from the tapered section 18.

Optionally, the one-way drainage structure 7 further includes a first connecting pipe 8 and a fourth connecting pipe 24.

The liquid inlet is connected to a joint between each passage (e.g., the third passage 4) having a gas outlet end lower than a gas inlet end and a passage downstream therefrom (i.e., the second passage 3) through the first connecting pipe 8. The valve body 16 is detachably connected to the first connecting pipe 8.

The fourth connecting pipe 24 is detachably connected to the valve body 16, and is communicated with the drainage port.

The first connecting pipe 8 connects the one-way drainage structure 7 to the lower end of the second passage 3 through threaded connection, and is configured to drain the condensate water from the second passage 3. A middle portion of the partition plate 20 is connected to a spring to support the spring, and the spring is connected to the sphere 22, and is in a pre-compressed state between the sphere 22 and the partition plate 20. Through an elastic force of the spring, the spring may apply an elastic force to the sphere 22 in a direction towards the tapered section 18, so that the sphere 22 is made to be in contact with the inner wall of the tapered section 18 and block the valve cavity. **In** this way, the sphere 22 is attached to a conical side wall of the tapered section 18 of the one-way drainage structure 7 under a pre-tightening force of the spring. Under the combined action of a negative pressure of the water drainage unit 9 in the plant system and the force of the spring, the sphere 22 may close the valve cavity, which prevents the negative pressure of the water drainage unit 9 from leaking through the one-way drainage structure 7. When a large amount of condensate water is accumulated in the second passage 3, the force of the spring is overcome by a pressure of the condensate water, so that the sphere 22 is detached from the conical side wall of the tapered section 18 of the one-way drainage structure 7 to generate a gap, and the condensate water flows into the fourth connecting pipe 24 through the gap. The fourth connecting pipe 24 connects the one-way drainage structure 7 to a plant condensate water pipeline of the water drainage unit 9 through threaded connection, and drains the condensate water into the plant condensate water pipeline. A main function of the one-way drainage structure 7 is to drain the condensate water from the condensate water separation device to the plant condensate water pipeline, while preventing the negative pressure of the water drainage unit 9 from leaking into the condensate water separation device to affect a pressure of the exhaust unit 6.

Optionally, a temperature sensor 25 is provided in the second passage 3.

The temperature sensor is connected to the side wall of the second passage 3 through threaded connection, and a probe extends into the second passage 3 to sense a temperature of a gas in the second passage 3. If the temperature is too low, a control system may adjust power of the heating part 11 to raise the temperature of the gas in the second connecting pipe 10, so as to avoid generation of condensate water in the second connecting pipe 10 and prevent the condensate water from flowing back into the pressure control valve group. The first connecting pipe 8 connects the second passage 3 to the one-way drainage structure 7 through threaded connection, condensate water flowing back from the exhaust unit 6 and the third connecting pipe 12 is stored in the lower part of the second passage 3. Based on the principle that density of the condensate water is greater than that of the gas, the condensate water is separated from the gas; and the condensate water is stored in the second passage 3, and does not flow back to the first passage 2. The condensate water and a by-product in the water drainage unit 9 may be also prevented from flowing back into the pressure control valve group.

Optionally, the heating part 11 includes a heating wire spirally wound around the second connecting pipe 10.

The heating wire is electrified to heat the second connecting pipe 10 and the gas therein. With the heating wire spirally wound around the second connecting pipe 10, which is simple in structure and low in cost, heating power of the heating wire can be easily controlled with the temperature sensor 25.

Optionally, the refrigeration part 13 includes a cooling jacket, a cooling cavity is provided in the cooling jacket, and a water inlet pipe 26 and a water outlet pipe 27, which are communicated with the cooling cavity, are disposed at an outer side of the cooling jacket.

The water inlet pipe 26 and the water outlet pipe 27 are configured to introduce cooling water into the cooling cavity and discharge the cooling water from the cooling cavity, respectively. By cooling the third connecting pipe 12 and the gas therein with the cooling water, a condensation effect can be promoted, so that the water vapor in the third connecting pipe 12 can condense in the third connecting pipe 12 as much as possible, and the condensate water can flow back into the second passage 3 and drained through the one-way drainage structure 7, thereby preventing the water vapor from entering the exhaust unit 6.

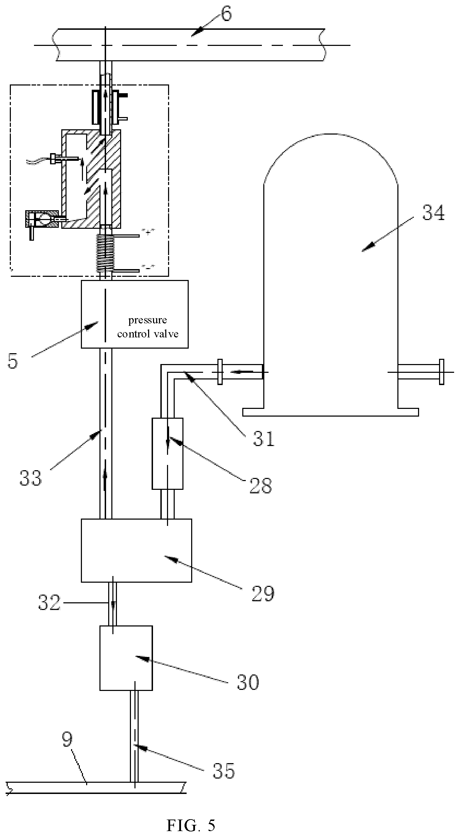

As shown in FIG. 5, the present disclosure further provides a semiconductor process device, including a reaction chamber 34 and a gas discharge system. The gas discharge system includes:
an exhaust pipeline connected to the reaction chamber 34;
a pressure control valve group 5 disposed on the exhaust pipeline; and
the condensate water separation device described above, with the gas inlet of the condensate water separation device detachably connected to an outlet end of the pressure control valve group 5.

The condensate water separation device is disposed between the pressure control valve group 5 of the gas discharge system and an exhaust unit 6 of a plant system, and the first passage 2 and the second passage 3 are independent of each other, and are connected through the oblique third passage 4 to form the zigzag gas passage. A gas enters from the gas inlet, passes through the zigzag gas passage, and then is discharged to the exhaust unit 6 through the gas outlet. After entering the second passage 3, condensate water in the exhaust unit 6 can hardly flow into the first passage 2, and may be drained to a water drainage unit 9 through the one-way drainage structure 7, so that the condensate water which flows back from the exhaust unit 6 can be prevented from entering the pressure control valve group 5.

In an example, the semiconductor process device is a diffusion furnace.

The gas discharge system is a gas discharge system of the diffusion furnace.

Optionally, the semiconductor process device further includes:
a tail-gas condensation device 28, a gas-liquid separation device 29, and a condensate water drainage device 30.

The gas-liquid separation device 29 is connected to the reaction chamber 34 through a first pipeline 31, the tail-gas condensation device 28 is disposed on the first pipeline 31, and a liquid outlet end and a gas outlet end of the gas-liquid separation device 29 are connected to the condensate water drainage device 30 and the pressure control valve group 5 through a second pipeline 32 and a third pipeline 33, respectively.

The gas outlet of the condensate water separation device is configured to be connected to the exhaust unit 6 of the plant system, the drainage port of the condensate water separation device is configured to be connected to the water drainage unit 9 of the plant system, and the condensate water drainage device 30 is connected to the water drainage unit 9 through a fourth pipeline 35.

A process gas which does not react in the reaction chamber 34 or a by-product generated during the process in the reaction chamber 34 is connected to the gas discharge system through the first pipeline 31, the reaction chamber 34 is connected to one end of the first pipeline 31 through a flange, the other end of the first pipeline 31 is connected to the tail-gas condensation device 28, water vapor in the first pipeline 31 may condense under a cooling effect of the tail-gas condensation device 28, water and gas are separated from each other in the gas-liquid separation device 29, and the water is conveyed into the condensate water drainage device 30 through the second pipeline 32 and then is drained into a plant condensate water pipeline of the water drainage unit 9 through the fourth pipeline 35; the third pipeline 33 is connected to an inlet end of the pressure control valve group 5, and the amount of gas discharged from the reaction chamber 34 to the gas discharge system is controlled with the pressure control valve group 5, so as to control a pressure in the chamber; the outlet end of the pressure control valve group 5 is connected to the gas inlet of the condensate water separation device through threaded connection, and the gas outlet of the condensate water separation device is connected to the water drainage unit 9 of the plant system through threaded connection; and the gas, which is obtained through separation by the tail-gas condensation device 28 at a front end, passes through the pressure control valve group 5 and then enters the condensate water separation device, and is subjected to water vapor condensation under the action of the refrigeration part to separate water from gas again, and the obtained water and the obtained gas are discharged to a pipeline of the exhaust unit 6 and a pipeline of the water drainage unit 9, respectively.

In summary, taking the semiconductor process device being the diffusion furnace as an example, the condensate water separation device described above is disposed between the pressure control valve group 5 of the gas discharge system of the semiconductor process device provided in the present disclosure and the exhaust unit 6. When the semiconductor process device is in use: the gas in the reaction chamber 34 passes through the tail-gas condensation device 28 and then enters the gas-liquid separation device 29, the liquid enters the second pipeline 32 and the condensate water drainage device 30 through the liquid outlet end of the gas-liquid separation device 29, the condensate water drainage device 30 can drain the condensate water to the water drainage unit 9, the gas enters the third pipeline 33 and the pressure control valve group 5 through the gas outlet end of the gas-liquid separation device 29, passes through the condensate water separation device, and then enters the exhaust unit 6; in the condensate water separation device, the gas sequentially passes through the second connecting pipe 10, the first passage 2, the third passage 4, the second passage 3, the fourth passage, and the third connecting pipe 12, the heating wire is electrified to heat the second connecting pipe 10 and the gas therein, so that the temperature of the gas is raised to 100C, thereby preventing the condensate water in the second connecting pipe 10 from flowing back to the pressure control valve group; since the first passage 2 and the second passage 3 are independent of each other, and are connected through the oblique third passage 4 to form the zigzag gas passage, the gas enters from the gas inlet, passes through the zigzag gas passage, and then is discharged to the exhaust unit 6 through the gas outlet, the condensate water in the exhaust unit 6 can hardly flow into the first passage 2 after entering the second passage 3, and can be drained to the water drainage unit 9 through the one-way drainage structure 7, so that the condensate water which flows back from the exhaust unit 6 can be prevented from entering the pressure control valve group 5; the cooling water is introduced into the refrigeration part, so that the gas in the third connecting pipe 12 can further condense, and the condensate water in the third connecting pipe 12 can flow into the lower end of the second passage 3 and is drained to the water drainage unit 9 through the one-way drainage structure 7, thereby further preventing the condensate water from flowing back into the pressure control valve group; and the condensate water or the corrosive by-product in the water drainage unit 9 also flows through the third connecting pipe 12 and enters the second passage 3, and then is discharged to the water drainage unit 9 through the one-way drainage structure 7. The condensate water separation device is added at a back end of the gas discharge system, so that, on the one hand, the condensate water can be separated from a process tail gas at a back end of the pressure control valve group, and can be prevented from flowing back into the pressure control valve group to affect pressure control precision, and on the other hand, the condensate water or the by-product in the water drainage unit 9 can be prevented from flowing back into the pressure control valve group to corrode the pressure control valve group 5, which not only improves the pressure control stability of the reaction chamber 34, but also prolongs service life of the pressure control valve group 5.

The embodiments of the present disclosure are described above, but the above description is illustrative rather than exhaustive, and the present disclosure is not limited to the disclosed embodiments. Many modifications and changes are apparent to those of ordinary skill in the art without departing from the scope and spirit of the embodiments of the present disclosure.

## Claims

1. A condensate water separation device, wherein the condensate water separation device is applied to a gas discharge system of a semiconductor process device, the gas discharge system comprises an exhaust pipeline, a pressure control valve group is disposed on the exhaust pipeline, and the condensate water separation device comprises:
a device body, which is provided therein with a zigzag gas passage, the gas passage comprising a plurality of passages sequentially communicated with each other along a gas flow direction, and a gas inlet end of a most upstream passage of the plurality of passages being used as a gas inlet and configured to be connected to an outlet end of the pressure control valve group; a gas outlet end of a most downstream passage of the plurality of passages being used as a gas outlet and being higher than a gas inlet end of the most downstream passage; and at least one other passage of the plurality of passages having a gas inlet end and a gas outlet end lower than the gas inlet end; and
a one-way drainage structure, which is connected to a joint between the at least one other passage having the gas outlet end lower than the gas inlet end and a passage downstream therefrom, and is configured to drain condensate water flowing through the one-way drainage structure.

2. The condensate water separation device of claim 1, wherein the plurality of passages comprise a first passage, a second passage, and a third passage, a lower end of the first passage is open to form the gas inlet, an upper end of the first passage is connected to a gas inlet end of the second passage through the third passage which inclines downwards, and an upper end of the second passage is open to form the gas outlet; and the gas inlet end of the second passage is lower than the upper end of the second passage; and
one end of the one-way drainage structure is connected to a lower end of the second passage, and the other end of the one-way drainage structure forms a drainage port.

3. The condensate water separation device of claim 2, wherein the second passage comprises a first sub-passage and an oblique second sub-passage, an axis of the first sub-passage is parallel to an axis of the first passage, the first sub-passage is provided with the gas inlet end of the second passage, and is connected to the upper end of the first passage through the third passage, and a lower end of the first sub-passage is connected to the one end of the one-way drainage structure; and the first sub-passage is further provided with a gas outlet end connected to a lower end of the second sub-passage, and the gas outlet end of the first sub-passage is higher than the gas inlet end of the second passage; and
an upper end of the second sub-passage forms the gas outlet at the device body, and the gas outlet is disposed coaxially with the gas inlet.

4. The condensate water separation device of claim 1, wherein the one-way drainage structure comprises:
a valve body, which is provided therein with a valve cavity, the valve cavity comprising a first straight tube section, a tapered section, and a second straight tube section, which are connected to each other in sequence, and a liquid inlet being formed at the valve body at one end of the second straight tube section away from the tapered section and being connected to a joint of each passage having a gas outlet end lower than a gas inlet end and a passage downstream therefrom; and
a partition plate, which is disposed in the first straight tube section, and is provided with a plurality of through holes that connect two sides of the partition plate, a sphere being disposed on a side of the partition plate close to the tapered section and being in sliding fit with the first straight tube section, an elastic part being disposed between the sphere and the partition plate and being capable of applying, through an elastic force of the elastic part, an elastic force to the sphere in a direction towards the tapered section so as to enable the sphere to be in contact with an inner wall of the tapered section and block the valve cavity, and the first straight tube section forming a drainage port at the valve body on a side of the partition plate away from the tapered section.

5. The condensate water separation device of claim 4, wherein the one-way drainage structure further comprises:
a first connecting pipe, the liquid inlet being connected to the joint between each passage having a gas outlet end lower than a gas inlet end and the passage downstream therefrom through the first connecting pipe; and the valve body being detachably connected to the first connecting pipe; and
a fourth connecting pipe, which is detachably connected to the valve body, and is communicated with the drainage port.

6. The condensate water separation device of any one of claims 2 to 5, wherein the gas inlet is connected to a second connecting pipe, and a heating part is provided around the second connecting pipe.

7. The condensate water separation device of claim 6, wherein the heating part comprises a heating wire spirally wound around the second connecting pipe.

8. The condensate water separation device of any one of claims 2 to 5, wherein the gas outlet is connected to a third connecting pipe, and a refrigeration part is disposed around the third connecting pipe.

9. The condensate water separation device of claim 8, wherein the refrigeration part comprises a cooling jacket, a cooling cavity is provided in the cooling jacket, and a water inlet pipe and a water outlet pipe which are communicated with the cooling cavity are disposed at an outer side of the cooling jacket.

10. The condensate water separation device of any one of claims 1 to 5, wherein a temperature sensor is disposed in the most downstream passage.

11. A semiconductor process device, comprising a reaction chamber and a gas discharge system, the gas discharge system comprising:
an exhaust pipeline connected to the reaction chamber;
a pressure control valve group disposed on the exhaust pipeline; and
the condensate water separation device of any one of claims 1 to 10, the gas inlet of the condensate water separation device being detachably connected to an outlet end of the pressure control valve group.

12. The semiconductor process device of claim 11, further comprising:
a tail-gas condensation device, a gas-liquid separation device, and a condensate water drainage device;
wherein the gas-liquid separation device is connected to the reaction chamber through a first pipeline, the tail-gas condensation device is disposed on the first pipeline, and a liquid outlet end and a gas outlet end of the gas-liquid separation device are connected to the condensate water drainage device and the pressure control valve group through a second pipeline and a third pipeline, respectively; and
the gas outlet of the condensate water separation device is configured to be connected to an exhaust unit of a plant system, the drainage port of the condensate water separation device is configured to be connected to a water drainage unit of the plant system, and the condensate water drainage device is connected to the water drainage unit through a fourth pipeline.
